(19) Europäisches Patentamt
European Patent Office
Office européen des brevets

(11) Veröffentlichungsnummer: **0 318 780 A2**

(12) **EUROPÄISCHE PATENTANMELDUNG**

(21) Anmeldenummer: 88119286.8

(22) Anmeldetag: 21.11.88

(51) Int. Cl.⁴: **G03F 7/02**

(30) Priorität: 28.11.87 DE 3740432

(43) Veröffentlichungstag der Anmeldung:
07.06.89 Patentblatt 89/23

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Herrmann, Heinz, Dr., Dipl.- Chem.**
**Am Güldenplan 15**
**D-6200 Wiesbaden(DE)**

(54) **Lichtempfindliche Druckplatte für den Flexodruck.**

(57) Es wird eine lichtempfindliche Druckplatte für den Flexodruck aus
a) einer transparenten, flexiblen, maßbeständigen Kunststoffolie als Schichtträger,
b) einer Haftschicht, die chlorsulfoniertes Polyethylen enthält, und
c) einer lichthärtbaren, ein Elastomeres enthaltenden Schicht
beschrieben. Die Platte zeichnet sich durch verbesserte Haftung der lichthärtbaren Schicht am Schichtträger aus.

EP 0 318 780 A2

## Lichtempfindliche Druckplatte für den Flexodruck

Die Erfindung betrifft eine lichtempfindliche Druckplatte, die zur Herstellung von Druckformen für den Flexodruck geeignet ist.

Es ist bekannt, Hochdruck- oder Flexodruckformen durch bildmäßiges Belichten von lichthärtbaren, insbesondere photopolymerisierbaren Schichten und Auswaschen der ungehärteten Schichtbereiche mittels eines geeigneten Lösemittels herzustellen. Lichtempfindliche Materialien dieses Typs sind z. B. in den DE-A 22 15 090 und 29 42 183 beschrieben.

Lichtempfindliche Flexodruckplatten sind gewöhnlich mehrschichtig aufgebaut und setzen sich zumeist aus einem maßbeständigen Schichtträger, einer Haftschicht, einer photopolymerisierbaren oder photovernetzbaren elastomeren Schicht, einer nichtklebenden Deckschicht und einer abtrennbaren Schutzfolie zusammen.

Der Schichtträger kann aus Metall oder vorzugsweise einer maßbeständigen transparenten Kunststoffolie bestehen und dient zur Verstärkung und Einhaltung der Maßhaltigkeit der elastomeren Schicht beim Druck, die bis zu mehrere Millimeter dick sein kann. Um die lichthärtbare Schicht fest auf dem Schichtträger zu verankern, ist eine Haftschicht erforderlich, die z. B. aus einem Ein- oder Zweikomponentenkleber auf Poly

urethan- oder Polychloroprenbasis, wie er in den DE-A 31 00 175, 31 07 741, 24 44 118 und 31 37 416 beschrieben ist, aus einer polymerisierbaren Schicht (US-A 3 036 913) oder einem Gemisch aus Polyvinylchlorid und Polyvinylacetat (DE-A 33 19 676) besteht. Gemische aus speziellen Polyestern und Polyamiden, Polyurethanen oder Polyolefinen sind für den gleichen Zweck aus der EP-A 64 564 bekannt.

Die Verklebung der elastischen photopolymerisierbaren Schicht mit dem Träger mit Hilfe fester Polymerschichten erfolgt in der Regel durch Heißlaminieren bei Temperaturen, die die haftvermittelnde Polymerschicht zum Schmelzen bringen.

Viele der bekannten Haftschichten liefern Verklebungen ungenügender Festigkeit. Bei starker Beanspruchung des Laminats während der Herstellung oder Anwendung der Druckform kann eine Trennung der Flexodruckschicht vom Träger erfolgen.

Beim oft beschriebenen Einsatz von Zweikomponentenklebern machen sich die meist geringe Lagerfähigkeit der Rohstoffe und die begrenzte Topfzeit des Gemischs nachteilig bemerkbar. Ausgehärtete Zweikomponentenkleber sind zudem oft schwer löslich, so daß die Reinigung der Beschichtungsgeräte schwierig und teuer wird. Stark vernetzte Schichten schmelzen außerdem relativ hoch, so daß hohe Laminiertemperaturen erforderlich werden, die zu einer Schädigung der Photopolymerschicht führen können.

Aufgabe der Erfindung war es, eine lichtempfindliche Flexodruckplatte mit einem maßbeständigen, transparenten Schichtträger und einer damit haftfest verbundenen elastomeren lichthärtbaren Schicht vorzuschlagen, wobei die Haftverbindung einfach und bei mäßig erhöhter Temperatur herstellbar ist.

Erfindungsgemäß wird eine lichtempfindliche Druckplatte für den Flexodruck aus

a) einer transparenten, flexiblen, maßbeständigen Kunststoffolie als Schichtträger,

b) einer Haftschicht und

c) einer lichthärtbaren, ein Elastomeres enthaltenden Schicht

vorgeschlagen.

Die erfindungsgemäße Druckplatte ist dadurch gekennzeichnet, daß die Haftschicht chlorsulfoniertes Polyethylen enthält.

Erfindungsgemäß wird ferner ein Verfahren zur Herstellung einer lichtempfindlichen Druckplatte für den Flexodruck vorgeschlagen, das darin besteht, daß man auf eine transparente, flexible, maßbeständige Kunststoffolie eine Haftschicht aufbringt, die ein chlorsulfoniertes Polyethylen enthält, auf die Haftschicht eine lichthärtbare, ein Elastomeres enthaltende Schicht aufbringt und diese Schicht durch die Kunststoffolie und die Haftschicht hindurch ohne Vorlage in solchem Maße belichtet, daß an der der Haftschicht anliegenden Seite der lichthärtbaren Schicht eine dünne lichtgehärtete Unterschicht ausgebildet wird.

Die lichthärtbare Schicht kann als lichthärtbare Verbindung ein Polymeres enthalten, das bei Belichtung selbst oder durch einen lichtempfindlichen Vernetzer zum unlöslichen Zustand vernetzt wird. Sie ist vorzugsweise eine photopolymerisierbare Schicht, die neben dem elastomeren Bindemittel eine ethylenisch ungesättigte radikalisch polymerisierbare Verbindung und einen Photoinitiator enthält, der bei Belichtung freie Radikale bildet. Derartige Gemische sind bekannt und z. B. in den eingangs genannten Druckschriften beschrieben.

Als Elastomere können alle möglichen natürlichen und synthetischen Kautschuktypen eingesetzt werden. Vorzugsweise verwendet man Blockcopolymerisate aus Vinylverbindungen, z. B. Styrol, und Dienen, wie Butadien oder Isopren.

Als polymerisierbare, ethylenisch ungesättigte Monomere verwendet man meist Acryl- oder Methacrylsäureester von mehrwertigen Alkoholen, z. B. Hexandiol-1,6-diacrylat und Hexandiol-1,6-dimethacrylat. Aber auch andere Ester der Acryl- und Methacrylsäure mit ein- oder mehrwertigen Alkoholen können in der Schicht enthalten sein.

Darüber hinaus kann man auch andere ungesättigte Monomere einsetzen, z. B. Vinylester aliphatischer Monocarbonsäuren oder Maleinsäure- und Fumarsäureester usw.

Auf einen Teil elastomeres Bindemittel verwendet man 0,05 bis 0,3 Teile ethylenisch ungesättigtes Monomeres.

Als Photoinitiatoren in dem Gemisch können eine Vielzahl von Substanzen Verwendung finden. Beispiele sind solche, die sich vom Grundkörper der Benzophenone, Benzoine, Benzile, Benzilmonoketale, des Fluorenons, Thioxanthons, der Mehrkernchinone, Acridine und Chinoxaline ableiten; ferner Trichlormethyl-s-triazine, Trihalogenmethylgruppen enthaltende Carbonylmethylenheterocyclen gemäß DE-A 33 33 450 oder Acylphosphinoxidverbindungen, wie sie z. B. in der DE-A 31 33 419 beschrieben sind.

Die Initiatoren werden allgemein in einer Menge von 0,01 bis 10, vorzugsweise von 0,05 bis 5 Gew.-%, bezogen auf die nichtflüchtigen Bestandteile der Schicht, eingesetzt.

Die photopolymerisierbare Schicht kann außerdem noch Zusatzstoffe enthalten, die die Lagerfähigkeit, das Kopierverhalten und andere Eigenschaften verbessern. Übliche Zusatzstoffe sind z. B. thermische Polymerisationsinhibitoren, Farbstoffe, Antioxidantien, Antiozonantien, Weichmacher und Füllstoffe.

Die photopolymerisierbare Schicht kann einheitlich sein oder aus mehreren übereinanderliegenden Schichten verschiedener Zusammensetzung bestehen. Beispielsweise kann man zweilagige photopolymerisierbare Schichten verwenden, bei denen die dem Schichtträger abgewandte Lage nach der Polymerisation eine höhere Härte aufweist als die dem Träger zugewandte Lage. Die gesamte photopolymerisierbare Schicht hat im allgemeinen eine Dicke von 0,05 bis 7, vorzugsweise 0,2 bis 5 mm.

Über der photopolymerisierbaren Schicht können sich in bekannter Weise noch eine dünne, nicht klebende, im Entwickler lösliche Polymerschicht, z. B. aus löslichen Polyamiden, und eine dickere, abziehbare Schutzfolie befinden. Die Polymerschicht hat im allgemeinen eine Dicke von 1 bis 20µm, die Schutzfolie eine von etwa 50 bis 200µm.

Als dimensionsstabile Trägerfolien für die Photopolymerschicht verwendet man bevorzugt 50 bis 300µm dicke transparente Kunststoffolien, z. B. aus Polyestern, Polycarbonaten, Polyimiden oder dgl. Besonders bevorzugt werden Polyethylenterephthalatfolien. Falls der Träger zwischen einer Photopolymerschicht und einer gummielastischen Basisplatte angeordnet werden soll, kann die Dicke auch geringer sein, z. B. bis herab zu 10µm. Die Oberfläche der Polyethylenterephthalatfolie kann vorbehandelt sein, z. B. mit Trichloressigsäure, oder einen dünnen Polymervorstrich besitzen.

Die erfindungsgemäß eingesetzte Haftschicht, die die photopolymerisierbare Schicht fest auf der dimensionsstabilen Trägerfolie verankert, besteht aus chlorsulfoniertem Polyethylen, vorzugsweise in Kombination mit Vinylidenchloridpolymeren. Die Haftschicht enthält vorteilhafterweise noch Füllstoffe und/oder UV-Absorber bzw. Stoffe, die bei UV-Belichtung Radikale bilden.

Chlorsulfonierte Polyethylene sind Produkte, die durch Umsetzen von Polyethylen mit Chlor und Schwefeldioxid oder mit Sulfurylchlorid erhalten werden und Cl- und $SO_2Cl$-Gruppen enthalten. Alle handelsüblichen chlorsulfonierten Polyethylene mit einem Chlorgehalt zwischen 24 und 45 % und einem Schwefelgehalt zwischen 1,0 und 1,4 % können verwendet werden. Die besten Ergebnisse erzielt man mit den leichtlöslichen, niedrigviskosen Typen, z. B. einem Polymeren mit 43 % Chlor, 1,1 % Schwefel und der Dichte 1,26.

Die Schichten aus chlorsulfoniertem Polyethylen bilden beim Laminieren - und dem nachfolgenden Anbelichten des Laminats durch die Haftschicht hindurch - eine feste Haftung zu den elastischen photopolymerisierbaren Schichten aus. Die Haftung zur vorbehandelten Polyethylenterephthalat-Trägerfolie läßt aber zu wünschen übrig. Bei Schichtgewichten unter etwa 10 g/m² reißt die Haftschicht bei Beanspruchung des Verbunds leicht ein und trennt sich dann von der Trägerfolie. Durch Zusatz von löslichen chlorhaltigen Polymeren kann die Haftung auf der Trägerfolie deutlich verbessert werden.

Als Zusatz brauchbar sind z. B. nachchloriertes Polyvinylchlorid, Vinylchlorid/Vinylacetat-Copolymerisate mit ca. 90 % Vinylchlorid und Vinylidenchlorid-Copolymerisate mit mindestens 40 % Vinylidenchlorid. Besonders günstig sind Mischpolymerisate, die etwa gleiche Anteile Vinylchlorid und Vinylidenchlorid enthalten. Der Zusatz macht eine Senkung des Gewichts der Haftschicht auf Werte von 1 g/m² oder darunter möglich.

Das Mischungsverhältnis zwischen chlorsulfoniertem Polyethylen und Vinylchlorid/Vinylidenchlorid-Copolymerisat kann in weiten Grenzen schwanken. Vorzugsweise verwendet man auf einen Teil chlorsulfoniertes Polyethylen 1 bis 9 Teile Copolymerisat.

Die Festigkeit des Verbunds Trägerfolie/Photopolymerschicht hängt naturgemäß von der Glätte der Haftschicht ab. Gerunzelte oder rauhe Haftschichten ergeben eine höhere Verbundfestigkeit als glatte. Auch ein Zusatz von Füllstoffen zu der Haftschicht kann infolge Aufrauhung der Oberfläche zu besserer Verklebung führen. Als Füllstoffe eignen sich z. B. hochdisperse Kieselsäuren, Kaolin, Tonerde und Aluminiumstearat. Zur Vermeidung von Füllstoff-Agglomeraten sollten die feinpulvrigen Substanzen z. B. mit Hilfe einer Kugelmühle in der Haftschichtlösung dispergiert werden.

Erfindungsgemäß können die Haftschichten auch UV-Absorber und/oder im UV-Licht Radikale bildende Substanzen enthalten. Diese Zusätze verbessern in geeigneter Konzentration auf noch ungeklärte Weise die Festigkeit des Verbunds. Brauchbare UV-Absorber finden sich unter den Di- und Trihydroxybenzophenonen und den Hydroxyphenylbenzotriazolen. Zu den geeigneten Stoffen, die bei Bestrahlung mit UV-Licht Radikale bilden, zählen Halogenkohlenwasserstoffe, wie Chinaldintribromid oder Trichlormethyl-triazinderivate, o-Chinondiazide, Diazoniumsalze mit komplexem Anion und die bekannten Photopolymerisationsinitiatoren, wie sie oben erwähnt wurden, z. B. 9-Phenylacridin.

Die optimale Konzentration der UV-Absorber und der gegen UV-Licht empfindlichen Substanzen hängt auch von ihrer weichmachenden Wirkung ab und liegt bei 0,2 bis 15 % der Polymermenge, vorzugsweise bei 0,5 bis 5 %. Die Konzentration muß so niedrig gehalten werden, daß nicht allzuviel Substanz in die photopolymerisierbare Schicht eindiffundieren und dort die Kohäsion mindern kann.

Die Haftschicht kann zusätzlich weitere Stoffe enthalten, z. B. andere Polymere, Harze und Farbstoffe.

Zur Herstellung der erfindungsgemäßen Flexodruckplatte beschichtet man zunächst die Trägerfolie mit der Haftschicht. Die Komponenten der Haftschicht werden in einem geeigneten Lösemittel oder Lösemittelgemisch gelöst und auf die Folienbahn aufgetragen. Als Lösemittel eignen sich z. B. cyclische Ether, Ketone, Ester, aromatische Kohlenwasserstoffe, Halogenkohlenwasserstoffe und daraus hergestellte Mischungen. Alle bekannten und üblichen Beschichtungsmethoden können zum Aufbringen der Haftschichtlösung eingesetzt werden.

Die Verklebung der die Haftschicht tragenden Trägerfolie mit der photopolymerisierbaren Schicht erfolgt zweckmäßig durch Aufwalzen mit einer heißen Walze. Die dem Träger abgewandte Seite der lichtempfindlichen Schicht wird dabei durch eine Schutzfolie geschützt. Die Schutzfolie besteht in der Regel aus einer Trägerfolie und einer davon leicht abziehbaren, die Photopolymerschicht berührenden Polyamidschicht. Die Laminiertemperatur liegt vorzugsweise oberhalb 80° C. Die maximal anwendbare Temperatur richtet sich nach der Laminiergeschwindigkeit und darf nicht so hoch sein, daß die Trägerfolie während des Laminiervorgangs verformt oder daß die photosensitive Schicht thermisch geschädigt wird.

Die Herstellung der photopolymerisierbaren Schicht kann in bekannter Weise durch Eindampfen einer Lösung der Komponenten, durch Verpressen einer homogenen Knetmasse zwischen parallelen Platten oder durch Extrudieren durch eine Breitschlitzdüse und nachfolgendes Kalandrieren der Bahn erfolgen. Bei Herstellung nach der letztgenannten Methode ist es von Vorteil, die Schicht im heißen Zustand schon im Kalander mit der haftvermittelten Trägerfolie und der Schutzfolie zu vereinigen. Der Heißlaminierschritt wird dann überflüssig.

Soll auf die Rückseite der Trägerfolie eine nicht lichtempfindliche Weichgummi- oder elastische Schaumstoff-Platte aufgebracht werden, dann muß die Trägerfolie beidseitig mit der Haftschicht versehen werden. Das Aufbringen der rückseitigen Haftschicht kann vor, während oder nach dem Verbinden mit der photopolymerisierbaren Schicht geschehen. Falls die Herstellung des Verbunds nicht in einem Arbeitsgang erfolgt, muß die freiliegende Haftschicht beim Laminiervorgang mit einer leicht abziehbaren Folie geschützt werden, damit die Walzen des Laminators nicht verschmutzt werden.

Die beschriebenen Haftschichten verbinden photopolymerisierbare Schicht und Trägerfolie ohne weitere Nachbehandlung in einem für viele Anwendungszwecke ausreichenden Maß. Die Verbundfestigkeit nimmt jedoch deutlich zu, wenn man das Mehrschichtenelement durch die Trägerfolie hindurch kurzzeitig mit UV-Licht bestrahlt, z. B. 20 Sekunden mit einem 320-Watt-Röhrengerät.

Die Verarbeitung des mehrschichtigen Flexodruckplattenmaterials zu gebrauchsfertigen Druckformen geschieht in bekannter Weise. Zunächst erzeugt man einen Druckplattensockel durch gleichmäßige Belichtung des Elementes durch die Trägerfolie hindurch. Danach belichtet man die Gegenseite - nach Abziehen der Schutzfolie - durch eine Negativ-Filmvorlage. Anschließend wäscht man die unbelichteten, nicht gehärteten Partien mit einem geeigneten Entwickler, z. B. einem Gemisch aus Perchlorethylen und n-Butanol, aus. Die erhaltene klebrige Druckform wird durch Nachbehandeln, beispielsweise mit Bromwasser, durch Nachbelichten und Trocknen klebfrei gemacht und kann dann zum Drucken verwendet werden.

Die folgenden Beispiele beschreiben bevorzugte Ausführungsformen der Erfindung. Alle Prozente und Mengenverhältnisse sind, wenn nichts anderes angegeben ist, in Gewichtseinheiten zu verstehen. Gewichtsteile (Gt) und Volumteile (Vt) stehen im Verhältnis von g zu ccm.

Die in den Beispielen genannten Haftschichten wurden auf folgende Weise geprüft: Eine handelsübliche Flexodruckplatte (Nyloflex FA, BASF) wurde in 2,0 cm breite und ca. 15 cm lange Streifen geschnitten, die Oberfläche der photopolymerisierbaren Schicht eines Streifens dann durch Abziehen der Schutzfolie und der Polyamidhaut freigelegt. Die auf eine Polyethylenterephthalatfolie aufgebrachte Haftschicht wurde mit der freigelegten Photopolymerschicht in Kontakt gebracht und das gebildete Mehrschichtenelement dann durch einen Laminator geschickt. Die Temperatur der Laminatorwalzen lag bei ca. 150° C, die Durchlaufgeschwindigkeit betrug 0,5 m je Minute. Das Mehrschichtenelement wurde durch die aufgebrachte Haftschicht hindurch 50 s mit einem 320-Watt-Röhrengerät belichtet. Die Festigkeit des Verbunds wurde durch manuelles Abreißen der Trägerfolie oder durch einen Schältest mit graphischer Aufzeichnung der Abziehkraft bei einer Abziehgeschwindigkeit von 200 mm je Minute geprüft.

Als Trägerfolien für die Haftschichten dienten in allen Fällen 100 bzw. 125μm dicke handelsübliche Polyethylenterephthalatfolien mit einer Primer-Vorbehandlung als Haftgrundierung.

Beispiel 1

Auf die Trägerfolie wurden folgende Lösungen bei ca. 90 Umdrehungen je Minute aufgeschleudert:

```
a) 10 Gt Hypalon 30 1)  in 90 Gt Toluol
b) 14 "    "        30   in 90 "   "
c)  5 "    "        30  +  5 "  Ixan SGA/1 2)
                        in 90 "  Toluol/Butanon (1:1)
d)  3 "    "        30  +  7 "  Ixan SGA/1
                        in 90 "  Toluol/Butanon (3:7)
e)  2 "    "        30  +  8 "  Ixan SGA/1
                        in 90 "  Toluol/Butanon (1:4)
f)  1 "    "        30  +  9 "  Ixan SGA/1
                        in 90 "  Toluol/Butanon (1:9)
```

```
1) Hypalon 30 = chlorsulfoniertes Polyethylen,
   43 % Chlor, 1,1 % Schwefel, Dichte 1,26
   Hersteller: DuPont

2) Ixan SGA/1 = Vinylchlorid/Vinylidenchlorid-
   Copolymerisat, Dichte 1,55
   Hersteller: Solvay
```

Die Schichten a und c bis f hatten nach 1 Minute Trocknen bei 110° C ein Schichtgewicht von ca. 5,5 g/m², das Schichtgewicht von b betrug 11,7 g/m².

Die beschichteten Folien wurden - wie oben angegeben -mit der photopolymerisierbaren Schicht (PP) laminiert, das Mehrschichtenmaterial dann belichtet.

Beim manuellen Auseinanderziehen des Verbunds ergab sich das in Tabelle 1 zusammengestellte Ergebnis.

## Tabelle 1

| Schicht | Ergebnis |
|---|---|
| a | Haftschicht (HS) trennt sich vom Träger |
| b | ca. 20 % Trennung innerhalb PP, ca. 80 % zwischen HS und PP |
| c | ca. 30 % "         "         PP, ca. 70 % "         HS und PP |
| d | ca. 70 % "         "         PP, ca. 30 % "         HS und PP |
| e | ca. 70 % "         "         PP, ca. 30 % "         HS und PP |
| f | ca. 40 % "         "         PP, ca. 60 % "         HS und PP |

Beispiel 2

In 1000 Vt einer Haftschichtlösung aus 20 Gt Hypalon 30, 80 Gt Ixan SGA/1, 180 Gt Toluol und 720 Gt Butanon wurden 10 Gt Füllstoff mit Hilfe einer Rührwerkskugelmühle dispergiert. Die Suspensionen wurden auf die Trägerfolie geschleudert und getrocknet. Das Trockenschichtgewicht betrug 5 bis 6 g/m². Die mit den beschichteten Folien hergestellten Laminate aus Trägerfolie/- Haftschicht/Photopolymerschicht ergaben im maschinellen Schältest mit 2,0 cm breiten Streifen folgende Abziehkräfte: HS mit Spezial-Tonerde CTB 86 N/2 cm

HS mit Al-Stearat 1107 ca. 90 N/2 cm *

Bei handelsüblichen Flexodruckplatten benötigt man zum Abziehen der Trägerfolie von der Photopolymerschicht meistens nur Kräfte im Bereich von 5 bis 30 N/2 cm, bestenfalls bis zu 80 N/2 cm.

Beispiel 3

In 100 Vt der in Beispiel 2 genannten Haftschichtlösung wurden die in Tabelle 2 genannten Mengen UV-Absorber bzw. Radikalbildner gelöst. Mit den Lösungen wurden die Trägerfolien schleuderbeschichtet, so daß Trockenschichtgewichte von 5 bis 6 g/m² resultierten. Die Haftschichtfolie wurde - wie oben angegeben - mit der Photopolymerschicht verklebt, belichtet und dem Schältest unterworfen. Die gemessenen Kräfte, die zum Trennen der Laminate nötig waren, sind aus Tabelle 2 ersichtlich.

*) Trennung innerhalb der Photopolymerschicht

Tabelle 2

| Schältest mit 2,0 cm breiten Streifen | |
|---|---|
| Zusatz zur Haftschicht-Lösung | nötige Abziehkraft |
| ohne | 78 N/2 cm |
| 0,4 Gt 2-(2-Hydroxy-5-methyl-phenyl)-2H-benzotriazol | ca. 105 N/2 cm *) |
| 0,2 " 2-(2-Hydroxy-5-methyl-phenyl)-2H-benzotriazol | 108 N/2 cm |
| 1,0 " 2,3,4-Trihydroxybenzophenon | ca. 110 N/2 cm *) |
| 0,25 " 2,3,4-Trihydroxybenzophenon | 100 N/2 cm |
| 0,5 " Chinondiazid 1) | ca. 150 N/2 cm *) |
| 0,2 " 9-Phenylacridin | ca. 170 N/2 cm *) |
| 0,1 " 9-Phenylacridin | ca. 150 N/2 cm *) |
| 0,1 " 2-Stilbenyl-4,6-bis-trichlormethyl-s-triazin | 112 N/2 cm |
| 0,5 " Chinaldintribromid + 0,2 g Perylen | ca. 140 N/2 cm *) |
| 0,5 " 4-Morpholino-2,5-dibutoxy-benzoldiazonium-p-toluolsulfonat | ca. 100 N/2 cm *) |

*) Trennung des Laminates innerhalb der Photopolymerschicht
1) Ester aus 2,3,4-Trihydroxybenzophenon und 1,2-Naphthochinon-2-diazid-5-sulfonsäure

Beispiel 4

Beispiel 1 e wurde wiederholt, das hergestellte Laminat aber verschieden lang belichtet. Es ergaben sich folgende Abziehkräfte:

| 10 s Belichtung | 88 N/2 cm |
|---|---|
| 20 s Belichtung | ca. 105 N/2 cm *) |
| 50 s Belichtung | 70 N/2 cm |

*) Trennung innerhalb der Photopolymerschicht

Beispiel 5

In einem Gemisch aus 18 Gt Toluol und 72 Gt Butanon wurden 2 Gt Hypalon 30 und 8 Gt Ixan SGA/1 gelöst. Die Hälfte der Lösung wurde mit 0,03 Gt Viktoriareinblau FGA (C.I. Basic Blue 81) angefärbt, die andere Hälfte wurde ohne Farbstoffzusatz verwendet. Beide Lösungen wurden auf Trägerfolien aufgeschleudert. Das Trockenschichtgewicht betrug 3 g/m$^2$.

Beide Schichten lieferten beim Laminieren mit den photopolymerisierbaren Schichten handelsüblicher Flexodruckplatten Produkte mit gleich guter Schichthaftung. Die zum Aufbau eines Reliefsockels erforderliche Lichtmenge wurde durch den Farbstoffzusatz nicht verändert.

**Ansprüche**

1. Lichtempfindliche Druckplatte für den Flexodruck aus

a) einer transparenten, flexiblen, maßbeständigen Kunststoffolie als Schichtträger,
b) einer Haftschicht und
c) einer lichthärtbaren, ein Elastomeres enthaltenden Schicht,

dadurch gekennzeichnet, daß die Haftschicht chlorsulfoniertes Polyethylen enthält.

2. Druckplatte nach Anspruch 1, dadurch gekennzeichnet, daß das chlorsulfonierte Polyethylen einen Chlorgehalt von 24 bis 45 Gew.-% hat.

3. Druckplatte nach Anspruch 1, dadurch gekennzeichnet, daß die Haftschicht eine Dicke von 0,1 bis 50μm hat.

4. Druckplatte nach Anspruch 1, dadurch gekennzeichnet, daß die Haftschicht zusätzlich ein Vinylchlorid/Vinylidenchlorid-Copolymeres enthält.

5. Druckplatte nach Anspruch 4, dadurch gekennzeichnet, daß das Mengenverhältnis von chlorsulfoniertem Polyethylen zu Copolymerem im Bereich von 1:1 bis 1:9 liegt.

6. Druckplatte nach Anspruch 1, dadurch gekennzeichnet, daß die Haftschicht zusätzlich im Ultraviolettbereich absorbierende Verbindungen oder feinteilige Pigmente enthält.

7. Druckplatte nach Anspruch 1, dadurch gekennzeichnet, daß die lichthärtbare Schicht durch die Haftschicht hindurch ohne Vorlage anbelichtet worden ist.

8. Druckplatte nach Anspruch 1, dadurch gekennzeichnet, daß die lichthärtbare Schicht photopolymerisierbar ist.

9. Druckplatte nach Anspruch 1, dadurch gekennzeichnet, daß die lichthärtbare Schicht eine Dicke von 0,05 - 7 mm hat.

10. Druckplatte nach Anspruch 1, dadurch gekennzeichnet, daß die transparente Kunststoffolie eine Polyesterfolie ist.

11. Verfahren zur Herstellung einer lichtempfindlichen Druckplatte für den Flexodruck, dadurch gekennzeichnet, daß man auf eine transparente, flexible, maßbeständige Kunststoffolie eine Haftschicht aufbringt, die ein chlorsulfoniertes Polyethylen enthält, auf die Haftschicht eine lichthärtbare, ein Elastomeres enthaltende Schicht aufbringt und diese Schicht durch die Kunststoffolie und die Haftschicht hindurch ohne Vorlage in solchem Maße belichtet, daß an der der Haftschicht anliegenden Seite der lichthärtbaren Schicht eine dünne lichtgehärtete Unterschicht ausgebildet wird.